(19) Europäisches Patentamt
European Patent Office
Office européen des brevets

(11) **EP 4 432 328 A1**

(12) **EUROPEAN PATENT APPLICATION**
published in accordance with Art. 153(4) EPC

(43) Date of publication:
**18.09.2024 Bulletin 2024/38**

(21) Application number: **22892632.5**

(22) Date of filing: **28.10.2022**

(51) International Patent Classification (IPC):
*H01J 37/06* (2006.01)     *H01J 37/073* (2006.01)
*H01J 37/28* (2006.01)     *H01J 1/34* (2006.01)

(52) Cooperative Patent Classification (CPC):
**H01J 1/34; H01J 37/06; H01J 37/073; H01J 37/28**

(86) International application number:
**PCT/JP2022/040542**

(87) International publication number:
**WO 2023/085133 (19.05.2023 Gazette 2023/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **09.11.2021 JP 2021182797
31.03.2022 JP 2022058504**

(71) Applicant: **Photo Electron Soul Inc.
Nagoya-shi, Aichi 460-0008 (JP)**

(72) Inventor: **IIJIMA, Hokuto
Nagoya-shi, Aichi 460-0008 (JP)**

(74) Representative: **Heyerhoff Geiger GmbH & Co. KG
Heiligenbreite 52
88662 Überlingen (DE)**

(54) **ELECTRON GUN, ELECTRON BEAM APPLICATION DEVICE, AND METHOD FOR FORMING MULTI-ELECTRON BEAM**

(57)     An object is to provide an electron gun, an electron beam applicator, and a multi-electron beam forming method that can form more electron beams than the number of lenses of a multi-lens array. The object can be achieved by an electron gun including: an electron source configured to generate releasable electrons; an anode configured to form an electric field between the electron source and the anode, extract the releasable electrons by the formed electric field, and form electron beams; and a multi-lens array, in which when electron beams with which the multi-lens array is irradiated are defined as first electron beams, m first electron beams (m is any integer of two or greater) are formed, the multi-lens array has n lenses (n is any integer of two or greater), and when electron beams emitted from the multi-lens array are defined as second electron beams, a maximum of m x n second electron beams can be formed.

FIG. 1

**Description**

[Technical Field]

The disclosure in the present application relates to an electron gun, an electron beam applicator, and a multi-electron beam forming method.

[Background Art]

Devices that generate a plurality of electron beams (multiple electron beams) are known.

As a related art, Patent Literature 1 discloses using a correction electron optics to form a plurality of electron beams from a single electron beam emitted from an electron gun. Patent Literature 1 discloses an arrayed correction electron optics having a plurality of holes formed therein through which electron beams pass. Further, in each of the holes, a blanking electrode having a deflecting function, an aperture diaphragm having an aperture (AP) defining the shape of a transmitting electron beam, a wiring, a unipotential lens, and a blanking opening are formed.

[Citation List]

[Patent Literature]

Patent Literature 1: Japanese Patent Application Laid-Open No. 9-245708

[Summary of Invention]

[Technical Problem]

The art disclosed in Patent Literature 1 can form a plurality of electron beams from a single electron beam by causing the electron beam to pass through the arrayed correction electron optics. Thus, the larger the number of holes of the arrayed correction electron optics is, the more the electron beams can be formed from a single electron beam. However, the arrayed correction electron optics disclosed in Patent Literature 1 requires micromachining to form electrodes or the like in respective holes. Thus, even a defect occurring in only a single hole makes a whole array be a defective product (hereafter, a hole having a lens function through which an electron beam passes may be referred to as "lens", and an array in which two or more "lenses" are formed may be referred to as "multi-lens array"), and there is a problem that the larger the number of holes is, the lower the yield of manufacturing of a multi-lens array will be. Further, even when a defect occurring in only a single lens during use, this requires replacement of a whole multi-lens array, and there is a problem that the larger the number of lenses is, the higher the running cost in using electron beams will be.

The present application has been made to solve the above problems, and according to intensive study, it has been newly found that, by irradiating a multi-lens array having n lenses (n is any integer of two or greater) with m first electron beams (m is any integer of two or greater), a maximum of m × n second electron beams can be formed.

The disclosure in the present application intends to provide an electron gun, an electron beam applicator, and a multi-electron beam forming method that can form more electron beams than the number of lenses of a multi-lens array.

[Solution to Problem]

The disclosure in the present application relates to an electron gun, an electron beam applicator, and a multi-electron beam forming method as illustrated below.

**[0009]**

　(1) An electron gun including:

　　an electron source configured to generate releasable electrons;
　　an anode configured to form an electric field between the electron source and the anode, extract the releasable electrons by the formed electric field, and form electron beams; and
　　a multi-lens array,
　　wherein when electron beams with which the multi-lens array is irradiated are defined as first electron beams,
　　m first electron beams (m is any integer of two or greater) are formed,
　　wherein the multi-lens array includes n lenses (n is any integer of two or greater), and
　　wherein the electron gun is configured to, when electron beams emitted from the multi-lens array are defined as second electron beams, form a maximum of m × n second electron beams when individual lenses of the multi-lens array are irradiated with the first electron beams from different positions.

(2) The electron gun according to (2) defined above, wherein the electron source is a photocathode.

(3) The electron gun according to (1) defined above, wherein the electron source includes at least one field emitter or Schottky-type.

(4) The electron gun according to (1) defined above, wherein the electron source includes at least one thermionic cathode.

(5) The electron gun according to any one of (1) to (4) defined above further including a control unit,

wherein the control unit is configured to, when a direction from the electron source to the multi-lens array is defined as a Z direction and emission positions from which the m first electron beams are emitted are defined as first electron beam emission positions, control a positional relationship between the first electron beam emission positions and the lenses of the multi-lens array when viewed in the Z direction to be a preset positional relationship.

(6) The electron gun according to (5) defined above further including a rotation mechanism that rotates the multi-lens array about the Z direction as a rotation axis,

wherein the control unit controls the rotation mechanism.

(7) The electron gun according to (5) defined above further including a motion mechanism that moves the multi-lens array in the Z direction as a motion direction,

wherein the control unit controls the motion mechanism.

(8) The electron gun according to (5) defined above, wherein when arrangement of the first electron beam emission positions is defined as emission arrangement, and arrangement of lenses of the multi-lens array is defined as lens arrangement,

the emission arrangement and the lens arrangement are the same or geometrically similar arrangement, and when the emission arrangement viewed in the Z direction is defined as a reference, the lens arrangement viewed in the Z direction is arranged at a position rotated about the center of the emission arrangement as a rotation axis so as not to be the same as or geometrically similar arrangement to the emission arrangement.

(9) The electron gun according to (8) defined above, wherein the emission arrangement and the lens arrangement are any one selected from a group consisting of

three or more odd number of points aligned linearly at equal intervals,
the four corners and the center of a square, and the six corners and the center of a regular hexagon.

(10) An electron beam applicator including the electron gun according to any one of (1) to (4) defined above, wherein the electron beam applicator is:

a free electron laser accelerator,
an electron microscope,
an electron holography device,
an electron beam drawing device,
an electron diffractometer,
an electron beam inspection device,
an electron beam metal additive manufacturing device,
an electron beam lithography device,
an electron beam processing device,
an electron beam curing device,
an electron beam sterilization device,
an electron beam disinfection device,
a plasma generation device,
an atomic element generation device,
a spin-polarized electron beam generation device,
a cathodoluminescence device, or
an inverse photoemission spectroscopy device.

(11) A multi-electron beam forming method including:

a first electron beam forming step; and

a second electron beam forming step,
wherein the first electron beam forming step includes
emitting m first electron beams (m is any integer of two or greater) from an electron source by forming an electric field between the electron source configured to generate releasable electrons and an anode, or
forming m first electron beams (m is any integer of two or greater) by forming an electric field between the electron source configured to generate releasable electrons and an anode to extract an electron beam and dividing the extracted electron beam, and
wherein the second electron beam forming step includes
forming a maximum of m × n second electron beams by irradiating a multi-lens array having n lenses (n is any integer of two or greater) with the m first electron beams and causing the first electron beams to enter individual lenses of the multi-lens array, the individual lenses being irradiated with the first electron beams from different positions.

(12) The multi-electron beam forming method according to (11) defined above, wherein the electron source is any one selected from a group consisting of a photocathode, a field emitter, and a Schottky-type.

(13) The multi-electron beam forming method according to (11) defined above,

wherein the electron source is a thermionic cathode, and
wherein the first electron beam forming step includes
forming m first electron beams (m is any integer of two or greater) by forming an electric field between the electron source configured to generate releasable electrons and an anode to extract an electron beam and dividing the extracted electron beam.

(14) The multi-electron beam forming method according to any one of (11) to (13) defined above, wherein when a direction from the electron source to the multi-lens array is defined as a Z direction and emission positions at which the first electron beams are emitted when emitted from the electron source are defined as first electron beam emission positions, a positional relationship between the first electron beam emission positions and the lenses of the multi-lens array when viewed in the Z direction is controlled to be a preset positional relationship.

(15) The multi-electron beam forming method according to (14) defined above,

wherein when arrangement of the first electron beam emission positions is defined as emission arrangement, and arrangement of lenses of the multi-lens array is defined as lens arrangement,
the emission arrangement and the lens arrangement are the same or geometrically similar arrangement, and when the emission arrangement viewed in the Z direction is defined as a reference, the lens arrangement viewed in the Z direction is arranged at a position rotated about the center of the emission arrangement as a rotation axis so as not to be the same as or geometrically similar arrangement to the emission arrangement.

Further, the electron gun, the electron beam applicator, and the multi-electron beam forming method disclosed in the present application can also employ embodiments described below.

(1) An electron gun including:

an electron source configured to generate releasable electrons;
an anode configured to form an electric field between the electron source and the anode, extract the releasable electrons by the formed electric field, and form electron beams;
a multi-lens array; and
a control unit,
wherein when electron beams with which the multi-lens array is irradiated are defined as first electron beams, m first electron beams (m is any integer of two or greater) are formed,
wherein the multi-lens array has n lenses (n is any integer of two or greater),
wherein the electron gun is configured to, when electron beams emitted from the multi-lens array are defined as second electron beams, form a maximum of m × n second electron beams when the first electron beams emitted from different positions enters individual lenses of the multi-lens array, and
wherein the control unit is configured to, when a direction from the electron source to the multi-lens array is defined as a Z direction and emission positions from which the m first electron beams are emitted are defined as first electron beam emission positions, control a positional relationship between the first electron beam emission positions and the lenses of the multi-lens array when viewed in the Z direction to be a preset positional relationship.

(2) The electron gun according to (1) defined above,

> wherein the electron source is a photocathode, and
> wherein the control unit controls a position of an excitation light beam received by the photocathode.

(3) The electron gun according to (1) defined above,

> wherein the electron source includes at least one field emitter or Schottky-type, and
> wherein the control unit controls elements that cause the field emitter or the Schottky-type to emit the first electron beams.

(4) The electron gun according to any one of (1) to (3) defined above further including a rotation mechanism that rotates the multi-lens array about the Z direction as a rotation axis,
wherein the control unit controls the rotation mechanism.
(5) The electron gun according to any one of (1) to (4) defined above further including a motion mechanism that moves the multi-lens array in the Z direction as a motion direction,
wherein the control unit controls the motion mechanism.
(6) The electron gun according to any one of (1) to (5) defined above, wherein when arrangement of the first electron beam emission positions is defined as emission arrangement, and arrangement of lenses of the multi-lens array is defined as lens arrangement,

> the emission arrangement and the lens arrangement are the same or geometrically similar arrangement, and
> when the emission arrangement viewed in the Z direction is defined as a reference, the lens arrangement viewed
> in the Z direction is arranged at a position rotated about the center of the emission arrangement as a rotation
> axis so as not to be the same as or geometrically similar arrangement to the emission arrangement.

(7) The electron gun according to (6) defined above, wherein the emission arrangement and the lens arrangement are any one selected from a group consisting of

> three or more odd number of points aligned linearly at equal intervals,
> the four corners and the center of a square, and the six corners and the center of a regular hexagon.

(8) The electron gun according to (7) defined above, wherein when regions irradiated with the second electron beams formed on an image plane are defined as second electron beam irradiation regions, the second electron beam irradiation regions have shapes that completely fill an irradiation target without missing and overlapping.
(9) The electron gun according to (8) defined above,

> wherein the emission arrangement and the lens arrangement are formed of the four corners and the center of
> a square or the six corners and the center of a regular hexagon,
> wherein the emission arrangement and the lens arrangement satisfy equations below, and
> wherein when the emission arrangement viewed in the Z direction is defined as a reference, an angle of the
> lens arrangement viewed in the Z direction rotated about the center of the emission arrangement as a rotation
> axis from arrangement that is the same as or geometrically similar arrangement to the emission arrangement
> is represented by θ in the equations below,

$$P_s = \left|\vec{P_s}\right| = \sqrt{h^2 P^2 + i^2 P'^2 + 2hiPP'\cos\phi} \qquad (3)$$

$$\cos\theta = \frac{hP + iP'\cos\phi}{\sqrt{h^2 P^2 + i^2 P'^2 + 2hiPP'\cos\phi}} \qquad (5)$$

When

$$\vec{S} = (0,0) \ , \quad \left| \vec{R} \right| = \frac{u}{v} \left| \vec{P} \right| \qquad (6)$$

When

$$\vec{R} = (0,0) \ , \quad \left| \vec{S} \right| = \frac{u}{u+v} \left| \vec{P_S} \right| \qquad (7)$$

where

$P_s$: the distance from the center of the plurality of second electron beams formed when passing through a lens arranged at the center of the lens arrangement to the center of the plurality of second electron beams formed when passing through a lens arranged adjacent to the lens arranged at the center of the lens arrangement,

$\vec{P_S}$: a vector of the above $P_s$,

$P$: the distance from the center second electron beam of the plurality of second electron beams formed when passing through a lens arranged at the center of the lens arrangement to the second electron beam adjacent to the center second electron beam,

$\vec{P}$: a vector of the above $P$,

$P'$: the distance from the center second electron beam of the plurality of second electron beams formed when passing through a lens arranged at the center of the lens arrangement to the second electron beam adjacent to the center second electron beam,

$\vec{P'}$: vector of the above $P'$,

$h$: an integer,

$i$: an integer,

$\phi$: the angle formed between $\vec{P'}$ and $\vec{P}$,

$\theta$: the angle formed between $\vec{P}$ and $\vec{P_S}$,

$u$: the distance from the electron source to the multi-lens array,

$v$: the distance from the multi-lens array to the image plane,

$\vec{R}$: a vector from the center emission position of the emission arrangement to an emission position adjacent to the center emission position, and

$\vec{S}$: a vector from the center lens of the lens arrangement to a lens adjacent to the center lens.

(10) An electron beam applicator including the electron gun according to (9) defined above,

wherein the electron beam applicator is a scanning electron microscope,
an electron beam inspection device, or
a scanning transmission electron microscope.

(11) A multi-electron beam forming method including:

a first electron beam forming step; and
a second electron beam forming step,

wherein the first electron beam forming step includes

emitting m first electron beams (m is any integer of two or greater) from an electron source by forming an electric field between the electron source configured to generate releasable electrons and an anode, or

forming m first electron beams (m is any integer of two or greater) by forming an electric field between the electron source configured to generate releasable electrons and an anode to extract an electron beam and dividing the extracted electron beam, and

wherein the second electron beam forming step includes

forming a maximum of m × n second electron beams by irradiating a multi-lens array having n lenses (n is any integer of two or greater) with the m first electron beams and causing the first electron beams to enter individual lenses of the multi-lens array, the individual lenses being irradiated with the first electron beams from different positions, and

when a direction from the electron source to the multi-lens array is defined as a Z direction and emission positions at which the first electron beams are emitted when emitted from the electron source are defined as first electron beam emission positions, controlling a positional relationship between the first electron beam emission positions and the lenses of the multi-lens array when viewed in the Z direction to be a preset positional relationship.

(12) The multi-electron beam forming method according to (11) defined above,

wherein when arrangement of the first electron beam emission positions is defined as emission arrangement, and arrangement of lenses of the multi-lens array is defined as lens arrangement,

the emission arrangement and the lens arrangement are the same or geometrically similar arrangement, and when the emission arrangement viewed in the Z direction is defined as a reference, the lens arrangement viewed in the Z direction is arranged at a position rotated about the center of the emission arrangement as a rotation axis so as not to be the same as or geometrically similar arrangement to the emission arrangement.

(13) The multi-electron beam forming method according to (12) defined above, wherein when regions irradiated with the second electron beams formed on an image plane are defined as second electron beam irradiation regions, the second electron beam irradiation regions have shapes that completely fill an irradiation target without missing and overlapping.

(14) The multi-electron beam forming method according to (13) defined above,

wherein the emission arrangement and the lens arrangement are formed of the four corners and the center of a square or the six corners and the center of a regular hexagon,

wherein the emission arrangement and the lens arrangement satisfy equations below, and

wherein when the emission arrangement viewed in the Z direction is defined as a reference, an angle of the lens arrangement viewed in the Z direction rotated about the center of the emission arrangement as a rotation axis from arrangement that is the same as or geometrically similar arrangement to the emission arrangement is represented by θ in the equations below,

$$ P_s = \left| \vec{P_S} \right| = \sqrt{h^2 P^2 + i^2 P'^2 + 2hiPP' \cos\phi} \qquad (3) $$

$$ \cos\theta = \frac{hP + iP' \cos\phi}{\sqrt{h^2 P^2 + i^2 P'^2 + 2hiPP' \cos\phi}} \qquad (5) $$

When

$$ \vec{S} = (0,0) , \quad \left| \vec{R} \right| = \frac{u}{v} \left| \vec{P} \right| \qquad (6) $$

When

$$\vec{R} = (0,0) \ , \quad |\vec{S}| = \frac{u}{u+v}|\vec{P_S}| \qquad (7)$$

where

$P_s$: the distance from the center of the plurality of second electron beams formed when passing through a lens arranged at the center of the lens arrangement to the center of the plurality of second electron beams formed when passing through a lens arranged adjacent to the lens arranged at the center of the lens arrangement,

$\overrightarrow{P_S}$: a vector of the above $P_S$,

$P$: the distance from the center second electron beam of the plurality of second electron beams formed when passing through a lens arranged at the center of the lens arrangement to the second electron beam adjacent to the center second electron beam,

$\vec{P}$: a vector of the above $P$,

$P'$: the distance from the center second electron beam of the plurality of second electron beams formed when passing through a lens arranged at the center of the lens arrangement to the second electron beam adjacent to the center second electron beam,

$\overrightarrow{P'}$: vector of the above $P'$,

$h$: an integer,

$i$: an integer,

$\phi$: the angle formed between $\overrightarrow{P'}$ and $\vec{P}$,

$\theta$: the angle formed between $\vec{P}$ and $\overrightarrow{P_S}$,

$u$: the distance from the electron source to the multi-lens array,

$v$: the distance from the multi-lens array to the image plane,

$\vec{R}$: a vector from the center emission position of the emission arrangement to an emission position adjacent to the center emission position, and

$\vec{S}$: a vector from the center lens of the lens arrangement to a lens adjacent to the center lens.

(15) A multi-electron beam scanning method including a scanning step of scanning an irradiation target with multiple electron beams formed by the multi-electron beam forming method according to (14) defined above.

[Advantageous Effect]

The electron gun, the electron beam applicator, and the multi-electron beam forming method disclosed in the present application can reduce the number of lenses of a multi-lens array to be less than the number of second electron beams. Therefore, the yield of manufacturing of multi-lens arrays can be improved, and the running cost in using the electron gun or the electron beam applicator can be reduced.

[Brief Description of Drawings]

[FIG. 1] FIG. 1 is a diagram schematically illustrating an electron gun 1 and electron beam applicator 10 according to an embodiment.

[FIG. 2] FIG. 2 is a diagram illustrating an overview when the electron gun 1 according to the embodiment forms multiple electron beams.

[FIG. 3] FIG. 3 is a diagram illustrating an overview when the electron gun 1 according to the embodiment forms multiple electron beams.

[FIG. 4] FIG. 4 is a diagram illustrating an overview when the electron gun 1 according to the embodiment forms multiple electron beams.

[FIG. 5] FIG. 5 is a flowchart of a multi-electron beam forming method.

[FIG. 6] FIG. 6 is a diagram illustrating an overview of a second embodiment.

[FIG. 7] FIG. 7 is a diagram illustrating an example in which some irradiation regions of second electron beams B2 are overlapping.

[FIG. 8] FIG. 8 is a diagram illustrating an example in which some irradiation regions of second electron beams B2 are missing.

[FIG. 9] FIG. 9 is a diagram illustrating an overview of a third embodiment.

[FIG. 10] FIG. 10 is a diagram illustrating an overview of the third embodiment.

[FIG. 11] FIG. 11 is a diagram illustrating an overview of the third embodiment.

[FIG. 12] FIG. 12 is a diagram illustrating an overview of the third embodiment.

[FIG. 13] FIG. 13 is a diagram illustrating an overview of the third embodiment.

[FIG. 14] FIG. 14 is a diagram illustrating an overview of the third embodiment.

[FIG. 15] FIG. 15 is a diagram illustrating an overview of the third embodiment.

[FIG. 16] FIG. 16 is a diagram illustrating an overview of the third embodiment.

[Description of Embodiments]

An electron gun, an electron beam applicator, and a multi-electron beam forming method will be described below in detail with reference to the drawings. Note that, in the present specification, members having the same type of functions are labeled with the same or similar references. Further, duplicated description for the members labeled with the same or similar references may be omitted.

Further, the position, size, range, or the like of respective components illustrated in the drawings may be depicted differently from the actual position, size, range, or the like for easier understanding. Thus, the disclosure in the present application is not necessarily limited to the position, size, range, or the like disclosed in the drawings.

[Definition of Direction]

In the present specification, in a three-dimensional rectangular coordinate system with an X-axis, a Y-axis, and a Z-axis, a direction in which an electron beam formed by an electron source travels is defined as a Z direction. Note that the Z direction is, for example, the perpendicular downward direction, however, the Z direction is not limited to the perpendicular downward direction.

[Embodiment of Electron Gun and Electron Beam Applicator]

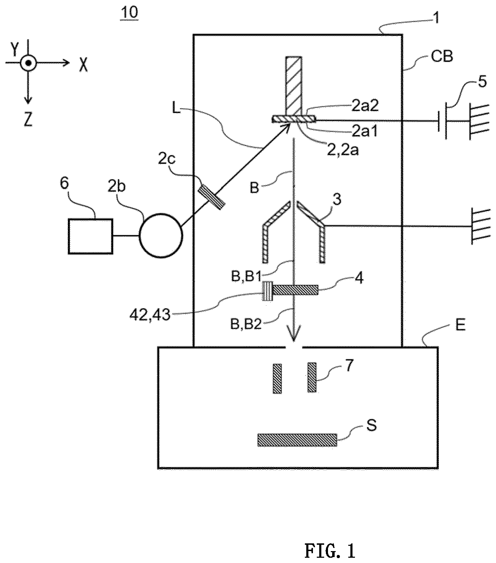

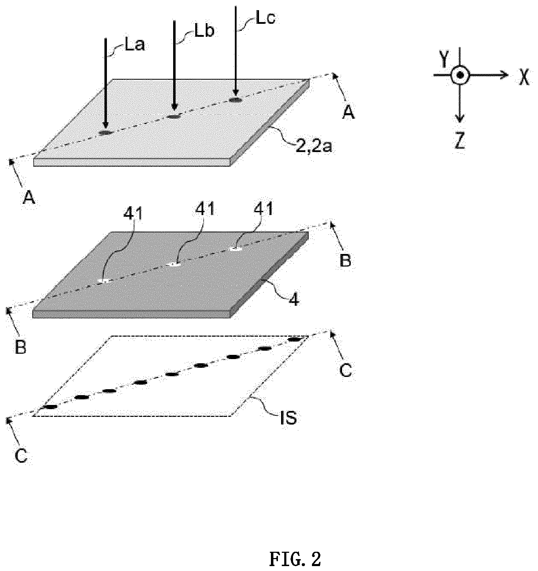

Embodiments of an electron gun 1, an electron beam applicator 10, and a multi-electron beam forming method will be described with reference to FIG. 1 to FIG. 4. FIG. 1 is a diagram schematically illustrating the electron gun 1 and the electron beam applicator 10 according to an embodiment. FIG. 2 to FIG. 4 are diagrams illustrating an overview when the electron gun 1 forms multiple electron beams according to the embodiment.

The electron gun 1 according to the embodiment includes at least an electron source 2, an anode 3, and a multi-lens array 4. The electron gun 1 may optionally and additionally include a power supply 5 for generating an electric field between the electron source 2 and the anode 3 and a control unit 6 for controlling the electron source 2 and the like. Further, although not illustrated, the electron gun 1 may include an accelerating electrode and an accelerating power supply for accelerating electron beams formed by the electron source 2 and the anode 3.

In the example illustrated in FIG. 1, a counterpart device E (the remaining portion of the electron beam applicator 10 when the electron gun 1 is removed) of the electron beam applicator 10 includes an electron beam deflector 7. The electron beam deflector 7 is used for scanning the irradiation target S with second electron beams B2 formed by the electron gun 1. Note that the example illustrated in FIG. 1 is an example of the counterpart device E. Although not illustrated, the counterpart device E can include a known component in accordance with the type of the electron beam applicator 10. Note that, since the example illustrated in FIG. 1 illustrates the overview of the entire electron gun 1 and electron beam applicator 10, the number of depicted electron beams B formed by the electron gun 1 is one. The overview of multiple electron beams in the electron gun 1 and the electron beam applicator 10 according to the embodiment will be described later in detail with reference to FIG. 2 to FIG. 4.

The electron source 2 is not particularly limited as long as it can generate releasable electrons and extract electrons generated by the electric field formed between the anode 3 and the electron source 2 to form the electron beam B, and a known electron source 2 can be used. The electron source 2 may include, for example, a photocathode, a field emitter, a Schottky-type, or a thermionic cathode. Note that, in the present specification, an electron beam with which the multi-lens array 4 is irradiated (an electron beam before passing through the multi-lens array 4) may be denoted as a first electron beam B1, and an electron beam after passing through the multi-lens array 4 (an electron beam emitted from the multi-lens array 4) may be denoted as a second electron beam B2. Further, when the first electron beam B1 and the second electron beam B2 are not particularly distinguished, these electron beams may be simply denoted as the electron beam B.

An example of the electron gun 1 in which a photocathode 2a is used as the electron source 2 will be described with reference to FIG. 1. The photocathode 2a generates releasable electrons in response to receiving an excitation light beam L emitted from a light source 2b. The principle of the photocathode 2a generating releasable electrons in response to receiving the excitation light beam L is well known (for example, see Japanese Patent No. 5808021 and the like).

The photocathode 2a is formed of a substrate of quartz glass, sapphire glass, or the like and a photocathode film (not illustrated) adhered to the first face 2a1 (the face on the anode 3 side) of the substrate. The photocathode material for forming the photocathode film is not particularly limited as long as it can generate releasable electrons in response to irradiation with the excitation light beam L and may be a material requiring EA surface treatment, a material not requiring EA surface treatment, or the like. The material requiring EA surface treatment may be, for example, Group III-V semiconductor materials or Group II-VI semiconductor materials. Specifically, the material may be AlN, $Ce_2Te$, GaN, a compound of one or more types of alkaline metals and Sb, or AlAs, GaP, GaAs, GaSb, InAs, or the like, and a mixed crystal thereof, or the like. The material may be a metal as another example and specifically may be Mg, Cu, Nb, $LaB_6$, $SeB_6$, Ag, or the like. The photocathode 2a can be fabricated by applying EA surface treatment on the photocathode material described above. For the photocathode 2a, suitable selection of the semiconductor material or the structure thereof makes it possible not only to select an excitation light beam in a range from near-ultraviolet to infrared wavelengths in accordance with gap energy of the semiconductor but also to achieve electron beam source performance (quantum yield, durability, monochromaticity, time response, spin polarization) in accordance with the use of the electron beam.

Further, the material not requiring EA surface treatment may be, for example, a single metal, an alloy, or a metal compound of Cu, Mg, Sm, Tb, Y, or the like or diamond, WBaO, $Cs_2Te$, or the like. The photocathode not requiring EA surface treatment can be fabricated by a known method (for example, see Japanese Patent No. 3537779 and the like) . The content disclosed in Japanese Patent No. 3537779 is incorporated in the present specification in its entirety by reference.

The light source 2b is not particularly limited as long as it can irradiate the photocathode 2a with an excitation light beam L to form the electron beam B. The light source 2b may be, for example, a high power (watt class), high frequency (several hundred MHz), ultrashort pulse laser light source, a relatively inexpensive laser diode, an LED, or the like. The excitation light beam L for irradiation can be any of pulsed light or continuous light and can be adjusted as appropriate in accordance with the purpose. Note that, in the example illustrated in FIG. 1, the light source 2b is arranged outside a vacuum chamber CB, and a first face 2a1 side of the photocathode 2a is irradiated with the excitation light beam L. Alternatively, the light source 2b may be arranged inside the vacuum chamber CB. Further, a second face 2a2 (a face on the opposite side of the anode 3) side of the photocathode 2a may be irradiated with the excitation light beam L.

The anode 3 is not particularly limited as long as it can generate an electric field together with the electron source 2, and any anode 3 generally used in the field of electron guns can be used. In the example illustrated in FIG. 1, when an electric field is formed between the photocathode 2a and the anode 3, the releasable electrons generated by irradiation with the excitation light beam L are extracted to the photocathode 2a, and thereby the electron beam B is formed.

Although the power supply 5 is connected to the photocathode 2a in order to form an electric field between the photocathode 2a and the anode 3 in the example illustrated in FIG. 1, the arrangement of the power supply 5 is not particularly limited as long as a potential difference occurs between the photocathode 2a and the anode 3.

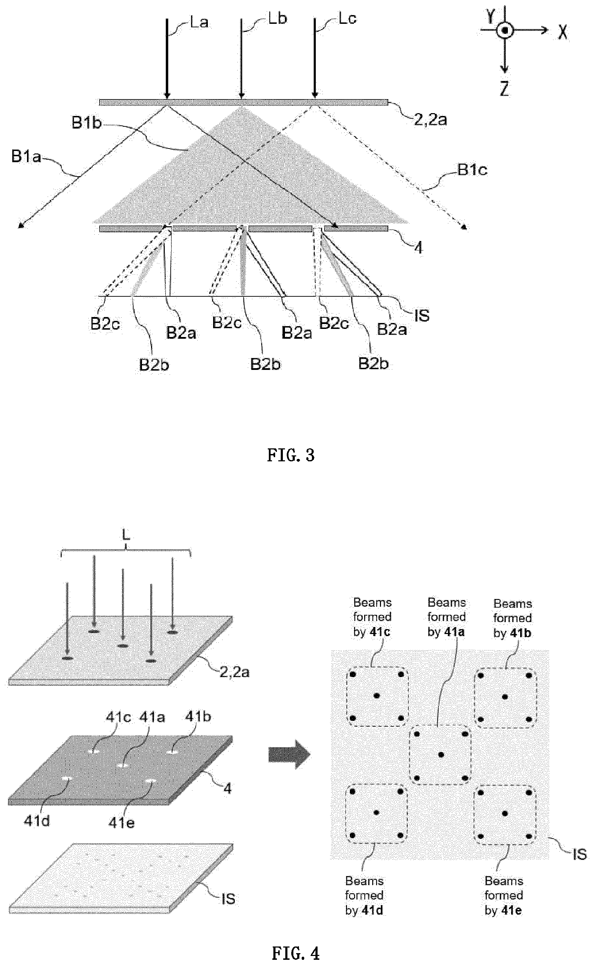

Next, the overview when the electron gun 1 according to the embodiment forms multiple electron beams will be described with reference to FIG. 2 to FIG. 4. In the example illustrated in FIG. 2 and FIG. 3, the photocathode 2a is irradiated with three excitation light beams La to Lc linearly at different locations, thereby three first electron beams B1a to B1c are formed (in FIG. 2, the first electron beams B1a to B1c are not illustrated, which are illustrated in FIG. 3), the multi-lens array 4 having three lenses 41 are irradiated with the formed three first electron beams B1a to B1c, thereby nine second electron beams B2a to B2c are formed (in FIG. 2, the second electron beams B2a to B2c are not illustrated, which are illustrated in FIG. 3), and nine focal points of the second electron beams B are formed on an image plane IS. Note that the image plane IS means a virtual plane on which the second electron beam B2 forms a focal point. The image plane IS may or may not match the surface of the irradiation target S. FIG. 3 is a sectional view taken along lines indicated by arrows A-A, B-B, and C-C of FIG. 2. Note that, although the anode 3 is present between the photocathode 2a and the multi-lens array 4, the anode 3 is not illustrated in FIG. 2 and FIG. 3 in order to avoid making these drawings complex.

The individual lenses 41 of the multi-lens array 4 have a function of, in response to incidence of the first electron beams B1a to B1c emitted from different positions, converging the incident first electron beams B1a to B1c, respectively, and forming focal points on the image plane IS. Thus, with irradiation of the multi-lens array 4 having n lenses 41 with m first electron beams B1, a maximum of m × n second electron beams B2 can be formed. Note that, to form a maximum of m × n second electron beams B2, the entire m first electron beams B1 are required to cover all the n lenses 41 of the multi-lens array 4.

To achieve the irradiation so that the entire m first electron beams B1 cover all the n lenses 41, adjustment can be made with suitable combination of adjustment of the degree of spread of the first electron beams B1, adjustment of irradiation positions of the m first electron beams B1, the arrangement of the n lenses 41, and the like, for example. It is possible to adjust the degree of spread of the first electron beams B1 by changing the intensity of the electric field formed between the electron source 2 and the anode 3. Note that the electron gun 1 disclosed in the present application is not necessarily required to form m x n second electron beams B2 from m first electron beams B1. There may be a lens 41 that one or some of the first electron beams B1 do not reach. In other words, it is only required for the electron gun 1 disclosed in the present application to be able to form m+1 or more or n+1 or more second electron beams B2 by irradiating the multi-lens array 4 having n lenses 41 with m first electron beams B1. The upper limits of m and n are not particularly limited as long as they can be achieved by the technical concept disclosed in the present application. Note that, to increase the numbers of m and n while avoiding an increase in size of the device, an advanced micromachining technology is required to, for example, reduce the interval of the lenses 41 arranged in the multi-lens array 4 or the like, which leads to an increase in costs. Therefore, the upper limits of m and n can be set as appropriate taking into consideration of a tradeoff of the advantage of increased number of the second electron beams B2, the size and cost of the device, and the like.

The number of first electron beams B1 may be greater than, equal to, or less than the number of lenses 41 (the integer of two or greater) as long as it is an integer of two or greater. Further, the arrangement of the first electron beams B1 (the positional relationship among the emitted m first electron beams B1, which are aligned linearly at equal intervals in the example illustrated in FIG. 2 and FIG. 3) and the arrangement of the lenses 41 (the positional relationship among the n lenses 41) may be the same or may be different from each other. Further, when the arrangement of the first electron beams B1 and the arrangement of the lenses 41 are the same, the arrangement of the first electron beams B1 and the arrangement of the lenses 41 may match as with the example illustrated in FIG. 2 or may be shifted in arrangement when viewed in the direction from the electron source 2 to the multi-lens array 4 (Z direction). Furthermore, although having the same shapes viewed in the Z direction, the arrangement of the first electron beams B1 and the arrangement of the lenses 41 may have geometrically similar shapes with different sizes.

Note that "shifted in arrangement" may refer to arrangement, for example, as described in (1) to (3) below based on the arrangement illustrated in FIG. 2.

(1) Change the position of any of the electron source 2 and the multi-lens array 4 in the X-Y plane direction. In other words, the arrangement of the first electron beams B1 and the arrangement of the lenses 41 do not match when viewed in the Z direction. In such a case, when viewed in the Z direction, all the positions to emit m first electron beams B1 are not necessarily required to match the lenses 41, or some of the positions to emit the first electron beams B1 may match the lenses 41.

(2) Rotate any of the electron source 2 and the multi-lens array 4 about the Z direction as the central axis. The rotation center is not particularly limited, and a point at which any one of the positions to emit the first electron beams B1 and the lens 41 match may be the rotation center, or a point at which the position to emit the first electron beam B1 and the lens 41 do not match may be the rotation center.

(3) Combination of (1) and (2) described above.

Although the first electron beams B1 and the lenses 41 are arranged linearly in the example illustrated in FIG. 2 and FIG. 3, such arrangement is a mere example. As described above, in the electron gun 1 according to the embodiment, the arrangement of the first electron beams B1 and the arrangement of the lenses 41 are not particularly limited as long as it can form m+1 or more or n+1 or more second electron beams B2 by irradiating the multi-lens array 4 having n lenses 41 with m first electron beams B1.

For example, in the example illustrated in FIG. 4, five first electron beams B1 are formed (the first electron beams B1 are not illustrated) by irradiation non-linearly (at five points of the four corners of a square and the center of the square) with five excitation light beams L. The formed five first electron beams B1 enter five lenses 41a to 41e of the multi-lens array 4, respectively. Therefore, as illustrated in the image plane IS on the right side in FIG. 4, since 5 second electron beams B2 are formed from each of the lenses 41a to 41e, 25 second electron beams B2 in total are formed. Naturally, the first electron beams B1 and the lenses 41 may be shifted in arrangement as described above also in the example illustrated in FIG. 4.

The method of forming the first electron beams B1 is not particularly limited as long as at least two or more first electron beams B1 are formed. When the electron source 2 is the photocathode 2a, the photocathode 2a may be irradiated with m excitation light beams L, as illustrated in FIG. 2 to FIG. 4. To irradiate the photocathode 2a with m excitation light beams L, m light sources 2b can be used. Alternatively, an optical splitter 2c such as a liquid crystal shutter may be arranged between the single light source 2b and the photocathode 2a as illustrated in FIG. 1, and the excitation light beam L emitted from the single light source 2b may be divided into a desired number of excitation light beams by the optical splitter 2c. Note that two or more light sources 2b and the optical splitter 2c may be combined. Further alternatively, the electron beam B may be first emitted from the photocathode 2a, and the emitted electron beams B may be then divided by using an aperture array or the like to form m first electron beams B1. Note that, when the electron beam B is divided as preset, an aperture array formed of a metal plate or the like may be used, for example. Further, when the number of divisions of the electron beam B or the positions of the first electron beams B1 to be formed is controlled, an aperture array with a blanking function (for example, an aperture array with deflecting function, an electrostatic lens array) may be used.

Although the example with the photocathode 2a used as the electron source 2 is illustrated in FIG. 1 to FIG. 4, a known electron source 2 such as field emitters, Schottky-type, thermionic cathodes, or the like as described above may be used. In such a case, the light source 2b and the optical splitter 2c illustrated in FIG. 1 are unnecessary. Further, elements of the field emitters and the Schottky-type can be arranged into an array. Therefore, in the case of the field emitters and the Schottky-type, m first electron beams B1 may be emitted from the arrayed elements, however, the electron beam B may be first emitted, and the emitted electron beam B may be then divided by using an aperture array or the like to form m first electron beams B1.

A thermionic cathode has a larger size as the electron source 2 than a photocathode, a field emitter, and a Schottky-type. Thus, although it is technically possible to arrange two or more thermionic cathodes, this may increase the size of the electron gun 1. Therefore, when the thermionic cathode is used as the electron source 2, not from a technical point of view but from a convenience point of view, it is preferable to first emit the electron beam B and then divide the emitted electron beam B by using an aperture array or the like to form m first electron beams B1.

For the anode 3, any anode generally used in the field of electron guns 1 can be used.

The multi-lens array 4 is not particularly limited as long as it has the function of converging the m first electron beams B1 that have entered respective lenses 41 to form m focal points on the image plane IS. For example, charged particle beam lens arrays disclosed in Japanese Patent Application Laid-Open No. 2013-30567, Japanese Patent Application Laid-Open No. 2014-53408, and the like can be used. All the features disclosed in Japanese Patent Application Laid-Open No. 2013-30567 and Japanese Patent Application Laid-Open No. 2014-53408 are incorporated in the present specification by reference.

FIG. 1 to FIG. 4 represent only an example of the electron gun 1 disclosed in the present application. Various modifications may be made as long as those fall in the scope of the technical concept disclosed in the present application. For example, in the example illustrated in FIG. 1, the control unit 6 that controls the light source 2b is provided. When a plurality of light sources 2b are provided, the control unit 6 can control which light source 2b emits the excitation light beam L and thereby control the number of first electron beams B1 to be formed. Further, when the optical splitter 2c is provided, the control unit 6 may control the optical splitter 2c to control the number of first electron beams B1 to be formed. Note that the photocathode 2a has a feature of emitting the electron beam B from a location at which the excitation light beam L is received. Therefore, when the photocathode 2a is used as the electron source 2, the control unit 6 may control the position of the excitation light beam L received by the photocathode 2a. Respective incident angles of the first electron beams B1 entering the multi-lens array 4 can be adjusted via a change of the irradiation position of the excitation light beam L. Therefore, even after the electron gun 1 has been assembled, in other words, even after the multi-lens array 4 has been set up, the control unit 6 can adjust the number of excitation light beams L to be emitted and/or the irradiation positions and thereby adjust the number of focal points formed on the image plane IS and the positional relationship between these focal points. Further, the control unit 6 may control the intensity of the excitation light beam L or may control the excitation light beam L to be emitted to the photocathode 2a as continuous light or pulsed light.

When arrayed field emitters and Schottky-type are used as the electron source 2, the control unit 6 may control which of the elements forming the array emits the electron beam B. When the elements are arranged in the row direction and the column direction, the number of elements to emit the electron beam B and/or the emission positions can be adjusted, and the same advantageous effect as that in the case of the photocathode 2a described above is thus achieved.

When a plurality of thermionic cathodes are used as the electron source 2, the control unit 6 can control which of the thermionic cathodes emits the electron beam B.

Further, regardless of the type of the electron source 2, when an aperture array with a blanking function is used as the aperture array that divides the electron beam B, the control unit 6 may control the member that exerts the blanking function (for example, an electrostatic lens or the like) to control the number or the location of the first electron beams B1 divided from the electron beam B.

The electron beam applicator 10 on which the electron gun 1 is mounted may be a known device on which an electron gun is mounted. For example, the electron beam applicator 10 may be a free electron laser accelerator, an electron microscope, an electron holography device, an electron beam drawing device, an electron diffractometer, an electron beam inspection device, an electron beam metal additive manufacturing device, an electron beam lithography device, an electron beam processing device, an electron beam curing device, an electron beam sterilization device, an electron beam disinfection device, a plasma generation device, an atomic element generation device, a spin-polarized electron beam generation device, a cathodoluminescence device, an inverse photoemission spectroscopy device, or the like.

The second electron beams B2 formed by the electron gun 1 disclosed in the present application can be adjusted as appropriate in accordance with the type of the electron beam applicator 10. For example, when the electron beam applicator 10 is a scanning electron microscope or a scanning electron beam inspection device, the image capturing time or the inspection time taken for a sample can be reduced by a scan with a plurality of linear second electron beams B2 formed as illustrated in FIG. 2. On the other hand, when a plurality of second electron beams B2 are formed planarly as illustrated in FIG. 4, the electron beam applicator 10 can also be used for a transmission electron microscope, an electron beam sterilization device, an electron beam disinfection device, or the like. Further, regardless of whether a scanning type or a non-scanning type, the electron beam applicator 10 can also be used for an electron beam drawing device (a mask drawing device, a direct drawing device), an electron beam metal additive manufacturing device (a metal 3D printer), or the like.

[Embodiment of Multi-Electron Beam Forming Method]

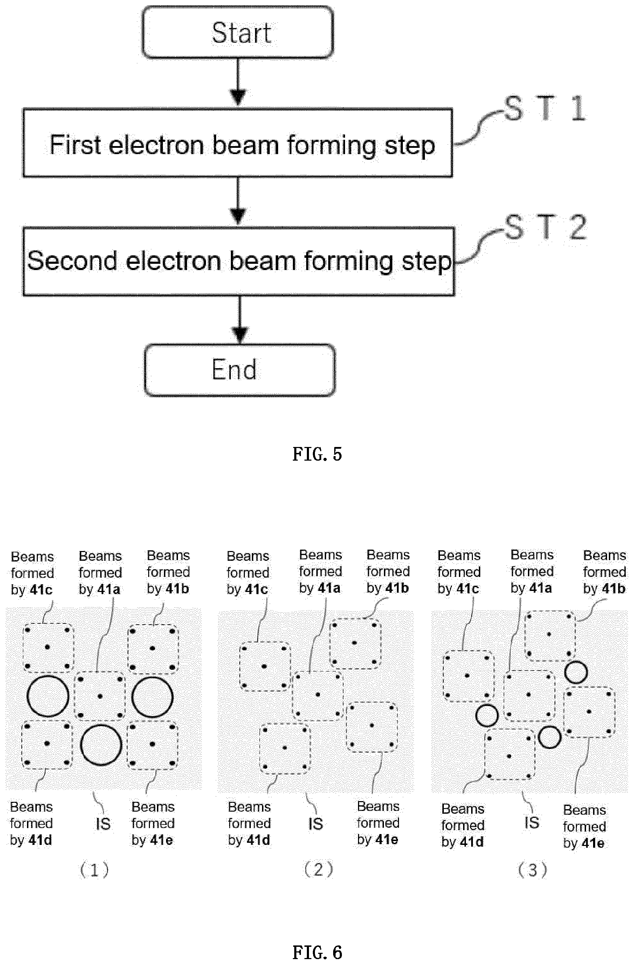

Next, a multi-electron beam forming method will be described with reference to FIG. 5. FIG. 5 is a flowchart of the multi-electron beam forming method. The multi-electron beam forming method includes a first electron beam forming step (ST1) and a second electron beam forming step (ST2).

In the first electron beam forming step (ST1), an electric field is formed between the electron source 2, which generates releasable electrons, and the anode 3 to emit m first electron beams B1 (m is any integer of 2 or greater) from the electron source 2. Alternatively, an electric field may be formed between the electron source 2, which generates releasable electrons, and the anode 3 to extract less than m electron beams B, and the extracted electron beams may be divided to form m first electron beams B1 (m is any integer of two or greater). As the electron source 2, a known electron source such as photocathodes, field emitters, Schottky-type, thermionic cathodes, or the like may be used as described in the embodiment of the electron gun 1. Note that, when a plurality of thermionic cathodes are used as the electron source 2, the electron gun 1 may be increased in size. Therefore, when the thermionic cathode is used as the electron source 2, it is preferable to first extract the electron beam B from the thermionic cathode and divide the extracted electron beams B to form m first electron beams B1 (m is any integer of two or greater).

In the second electron beam forming step (ST2), the m first electron beams B1 are emitted to the multi-lens array 4 having n lenses 41 (n is any integer of two or greater) to form a maximum of m × n second electron beams B2.

Note that, when the irradiation target S is scanned with the formed second electron beams B2, although not illustrated, a second electron beam B2 scanning step (ST3) and a second electron beam B2 irradiation step (ST4) may be included after the second electron beam forming step (ST2), the second electron beam B2 scanning step (ST3) performs a scan with the second electron beams B2 whose focal points are formed on the image plane IS while deflecting the second electron beams B by the electron beam deflector 7, and the second electron beam B2 irradiation step (ST4) irradiates the irradiation target S with the second electron beams B2 used for the scan. Further, when the scan with the formed second electron beams B2 is unnecessary, the second electron beam B2 irradiation step (ST4) may be performed after the second electron beam forming step (ST2).

The electron gun 1, the electron beam applicator 10 on which the electron gun 1 is mounted, and the multi-electron beam forming method disclosed in the present application (hereafter, "the electron gun 1, the electron beam applicator 10, and the multi-electron beam forming method" are collectively referred to as "electron gun and the like") achieve the following advantageous effects.

(1) For the same number of second electron beams B2 to be formed on the image plane IS (intended to irradiate the irradiation target S), it is possible to reduce the number of lenses 41 of the multi-lens array 4 to be smaller than that in Patent Literature 1 by irradiating the multi-lens array 4 with m first electron beams B1 in the electron gun and the like. Therefore, the probability of a defect occurring in any one of the lenses 41 in manufacturing the multi-lens array 4 is reduced, and this improves the yield of manufacturing of the multi-lens array 4. Further, when the number of lenses 41 is smaller, the probability of a defect occurring in any one of the lenses 41 in using the electron gun and the like is also smaller, and thus, the running cost of the electron gun and the like can be reduced.

(2) As illustrated in FIG. 3 and FIG. 4, the electron gun and the like disclosed in the present application can form focal points of the second electron beams B2 on the image plane IS at intervals narrower than the intervals of the lenses 41 by causing m first electron beams B1 from different emission positions to enter the lenses 41. Therefore, when it is assumed that the intervals of the second electron beams B2 formed on the image plane IS are the same, the intervals of the lenses 41 of the electron gun 1 can be wider than the holes of the lens 7 disclosed in Patent Literature 1. This facilitates manufacturing of the multi-lens array 4. Further, since the intervals of the lenses 41 can be increased, the size of each lens 41 can also be increased. With the increased size of the lens 41, it is possible to increase beam current (increase the brightness) of the electron beam B1 passing through each single lens 41.

(3) An embodiment in which the electron source 2 forms m first electron beams B1 without using the aperture array or the like is assumed. In such a case, in terms of forming m first electron beams B1, while any of the photocathode, the field emitter, the Schottky-type, and the thermionic cathode may be used, the size of the electron gun 1 can be smaller with the use of the photocathode, the field emitter, or the Schottky-type. Further, when elements of the field emitters or the Schottky-type are arrayed, the probability of a defect occurring in one of the elements forming the array during manufacturing or during use increases as the number of elements increases as with the lenses 41 of the multi-lens array 4. In contrast, the photocathode 2a can be manufactured as a single member by adhering a photocathode film to a substrate. Thus, when the photocathode 2a is used for the electron source 2 forming a plurality of first electron beams B1, the size of the electron gun and the like can be reduced, and the probability of a defect occurring during manufacturing or during use can be reduced.

(4) Further, with the photocathode 2a, it is possible to easily change the number and the arrangement of first electron beams B1 for emission by adjusting the number and the irradiation positions of excitation light beams L. Therefore, when the photocathode 2a is used as the electron source 2, even after the electron source 2 and the multi-lens array 4 have been set up in the electron gun, it is possible to adjust the number and the incident angles of first electron beams B1 entering the multi-lens array 4 and thereby adjust the number and the arrangement of second electron beams B2 formed on the image plane IS (intended to irradiate the irradiation target S), and thus, convenience in using the electron gun and the like is improved.

[Employable Configuration Example 1 in Embodiment of Electron Gun and Electron Beam Applicator]

Subsequently, an employable configuration example in the embodiment of the electron gun and the electron beam applicator (hereafter, the embodiment of the electron gun and the electron beam applicator employing this configuration example may be referred to as "second embodiment") will be described with reference to FIG. 1 to FIG. 6. FIG. 6 is a diagram illustrating the overview of the second embodiment.

As illustrated in FIG. 2 and FIG. 4, the electron gun 1 disclosed in the present application irradiates the lens array 4 having n lenses 41 with m first electron beams B1, and thereby a maximum of m × n second electron beams B2 can be formed on the image plane IS.

The present inventors have studied the positional relationship between emission positions when m first electron beams B1 are emitted (hereafter, which may be referred to as "first electron beam emission position") and the lenses 41 of the multi-lens array 4. As a result, it has been newly found that, by controlling the positional relationship between the first electron beam emission positions and the lenses 41 of the multi-lens array 4 when viewed in the Z direction (hereafter, this positional relationship may be referred to as "relative positional relationship"), it is possible to perform control so that the second electron beams B2 formed on the image plane IS are suitably arranged. The electron gun 1 according to the second embodiment includes the control unit 6 as one of the components. Further, the second embodiment is the same as described above (the embodiment of the electron gun and the electron beam applicator (hereafter, which may be referred to as "first embodiment")) except that the control unit 6 controls the relative positional relationship to be a preset positional relationship. Therefore, in the second embodiment, features different from the first embodiment will be mainly described, and the duplicated description for the features that have already been described in the first embodiment will be omitted. Accordingly, it is apparent that, even when not explicitly described in the second embodiment, any feature that has already been described in the first embodiment can be employed in the second embodiment.

The overview of control details of the control unit 6 of the second embodiment will be described with reference to FIG. 6. FIG. 6 (1) illustrates the second electron beams B2 formed on the image plane IS when the lens arrangement viewed in the Z direction is arranged so as to be the same as (so as to be overlapped) the emission arrangement, when the emission arrangement viewed in the Z direction is defined as a reference under the definitions that the arrangement of the first electron beam emission positions is defined as emission arrangement, the arrangement of the lenses 41 of the multi-lens array 4 is defined as lens arrangement, and as illustrated in FIG. 4, the emission arrangement and the lens arrangement are the same (have the same shape). Note that, in the present specification, "first electron beam emission position(s)" means positions at which m first electron beams B1 are emitted. More specifically, when m first electron beams B1 are extracted directly from the electron source 2, the locations of the electron source 2 at which electrons are extracted are the emission positions, and when an electron beam extracted from the electron source 2 is divided by an electron beam divider such as an aperture array to form m first electron beams B1, the location at which the m first electron beams B1 are emitted from the electron beam divider is the emission position.

FIG. 6 (2) illustrates the second electron beams B2 formed on the image plane IS when the lens arrangement has been arranged at a position rotated about the center of the emission arrangement as a rotation axis so that the lens arrangement viewed in the Z direction is not the same as the emission arrangement when the emission arrangement viewed in the Z direction is defined as a reference. FIG. 6 (3) illustrates the second electron beams B2 formed on the image plane IS when the lens arrangement is further rotated from the example illustrated in FIG. 6 (2) based on the emission arrangement as a reference. As is apparent from the examples illustrated in FIG. 6 (1) to (3), rotation of the lens arrangement based on the emission arrangement viewed in the Z direction as a reference changes the arrangement of the second electron beams B2 formed on the image plane IS. More specifically, in the example illustrated in FIG. 6 (1), spacings (portions indicated by circles in FIG. 6 (1)) between individual regions of the second electron beams B2 (hereafter, which may be referred to as "B2 individual lens region(s)") formed after passing through individual lenses 41 (a to e) have substantially the same size as the B2 individual lens region. In contrast, as illustrated in FIG. 6 (2) and

FIG. 6 (3), with rotation of the relative positional relationship of the lens arrangement relative to the emission arrangement, the spacings between the B2 individual lens regions (portions indicated by circles in FIG. 6 (3)) become smaller. For example, when the electron beam applicator is a non-scanning type electron beam sterilization device, a non-scanning type electron beam disinfection device, or the like, smaller spacings between the B2 individual lens regions result in smaller heating unevenness. Therefore, disinfection or sterilization efficiency can be increased. The degree the lens arrangement is rotated about the center of the emission arrangement as a rotation axis can be set as appropriate in accordance with the purpose.

Note that FIG. 6 represents the example when the emission arrangement and the lens arrangement viewed in the Z direction are the same (have the same shape). Alternatively, when the emission arrangement and the lens arrangement are geometrically similar arrangement (have geometrically similar shapes) and when the emission arrangement viewed in the Z direction is defined as a reference, the lens arrangement viewed in the Z direction may be arranged at a position rotated about the center of the emission arrangement as a rotation axis so as not to be geometrically similar arrangement to the emission arrangement. Further alternatively, the emission arrangement and the lens arrangement are not required to be the same or geometrically similar arrangement as long as a change in the relative positional relationship between the emission arrangement and the lens arrangement results in a smaller spacing between the B2 individual lens regions. In other words, the control unit 6 can control the relative positional relationship to be a preset positional relationship.

The relative positional relationship may be set during assembly of the electron gun 1 so as to be a preset positional relationship. In other words, the relative positional relationship can also be fixed so as not to be changed after the electron gun 1 has been assembled. However, fine adjustment may be necessary after the electron gun 1 has been assembled. It is therefore desirable that the control unit 6 can perform control to adjust the relative positional relationship after the electron gun 1 has been assembled.

When the electron source 2 is the photocathode 2a, the control unit 6 can control the position of the excitation light beam L received by the photocathode 2a. When the electron source 2 includes field emitters or Schottky-type, the control unit 6 can control the elements of the field emitters or the Schottky-type that emit the first electron beams B1.

As illustrated in FIG. 1, the electron gun 1 has a rotation mechanism 42 that rotates the multi-lens array 4 about the Z direction as an axis, and the control unit 6 may control the rotation mechanism 42 to control the relative positional relationship. The rotation mechanism 42 is not particularly limited as long as it can rotate the multi-lens array 4. For example, a gear that engages with the outer circumference of the multi-lens array 4 can be provided, and the gear can be rotated by a drive source such as a motor. When the electron gun 1 has the rotation mechanism 42, it is possible to control the relative positional relationship by adjusting the arrangement of the multi-lens array 4. Naturally, the control unit 6 may control both the electron source 2 and the rotation mechanism 42 of the multi-lens array 4.

When an electron beam extracted from the electron source 2 is divided by an electron beam divider to form m first electron beams B1, the control unit 6 can control the relative positional relationship by controlling the rotation mechanism 42 of the multi-lens array 4. Alternatively, although not illustrated, a rotation mechanism that rotates the electron beam divider (hereafter, which may be referred to as "divider rotation mechanism") may be provided, and the control unit 6 may control the relative positional relationship by controlling the divider rotation mechanism. The divider rotation mechanism can have the same mechanism as the rotation mechanism 42. Naturally, the control unit 6 can control both the rotation mechanism 42 and the divider rotation mechanism.

Further, as illustrated in FIG. 1, the electron gun 1 has a motion mechanism 43 that moves the multi-lens array 4 in the Z direction as a motion direction, and the control unit 6 may control the motion mechanism 43. As described later, by adjusting the distance between the first electron beam emission position and the multi-lens array 4, it is possible to control the beam interval of the second electron beams B2 formed on the image plane IS. The motion mechanism 43 is not particularly limited as long as it can move the multi-lens array 4 in the Z direction. For example, a rack and pinion mechanism and a drive source such as a motor may be provided.

Note that, when the control unit 6 controls the rotation mechanism 42 that rotates the multi-lens array 4, it is required for the electron gun 1 to employ the configuration of the rotation mechanism 42. In contrast, when the control unit 6 controls a photocathode, one or more field emitters, or one or more Schottky-type, the rotation mechanism 42 that rotates the multi-lens array 4 is unnecessary, and the electron gun 1 can be simplified. It is therefore more preferable that the control unit 6 control the photocathode, the field emitters, or the Schottky-type. Furthermore, unlike a field emitter or a Schottky-type, a photocathode has a feature of being able to quickly emit an electron beam from any location where the excitation light beam L is received. Therefore, when a photocathode is used as the electron source 2 and the control unit 6 controls the excitation light beam L received by the photocathode, it is possible to quickly perform control of adjusting the relative positional relationship to a preset positional relationship and/or fine adjustment of the relative positional relationship.

The electron gun 1 according to the second embodiment achieves an advantageous effect of being able to perform control so that the second electron beams B2 formed on the image plane IS are suitably arranged by controlling the relative positional relationship.

[Employable Configuration Example 2 in Embodiment of Electron Gun and Electron Beam Applicator]

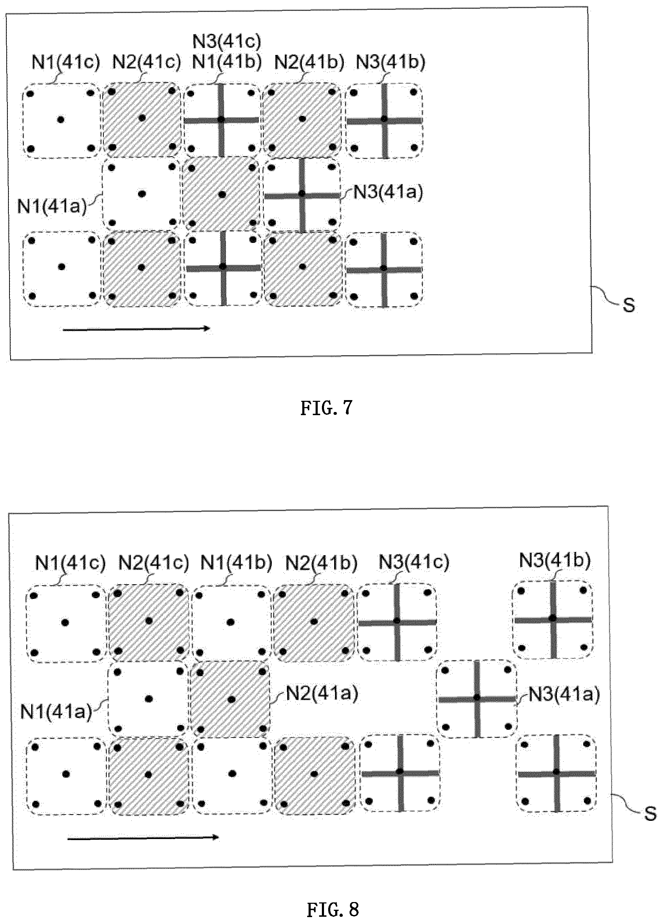

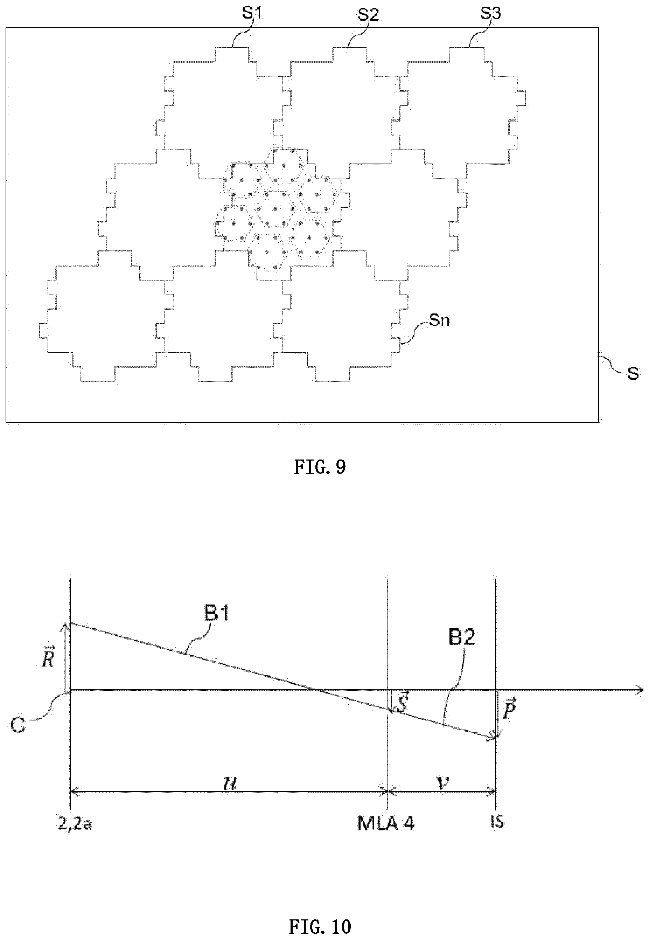

Next, an example in which the relative positional relationship disclosed in the second embodiment is more restricted will be described. Note that this embodiment is referred to as a third embodiment for illustration purposes. As a result of intensive study, the present inventors have newly found that, when the emission arrangement and the lens arrangement have a particular relationship, it is possible to scan the irradiation target S with the formed second electron beams B2 without missing or overlapping. The relationship between the emission arrangement and the lens arrangement will be described below in more detail with reference to the drawings. FIG. 7 is a diagram illustrating an example in which some irradiation regions of the second electron beams B2 are overlapping. FIG. 8 is a diagram illustrating an example in which some irradiation regions of the second electron beams B2 are missing. FIG. 9 to FIG. 16 are diagrams illustrating the overview of the third embodiment.

In the third embodiment, for example, a case where the electron gun 1 is mounted on the scanning type electron beam applicator 10 is assumed. As illustrated in FIG. 2, when it is possible to form the second electron beams B2 linearly on the image plane IS, it is possible to irradiate the irradiation target S with the second electron beams B2 without overlapping or missing by performing a scan with the formed linearly-aligned second electron beams B2 by using the electron beam deflector 7.

As illustrated in FIG. 4, a case where the second electron beams B2 are formed on the image plane IS non-linearly is assumed. In such a case, in the example illustrated in FIG. 7, first, $5 \times 5 = 25$ second electron beams B2 at the first time (the white portions surrounded by dotted lines in FIG. 7, for example, N1(41a), N1(41b), N1(41c)) are formed on the image plane IS and emitted to the irradiation target S. Then, $5 \times 5 = 25$ second electron beams B2 at the second time deflected by the electron beam deflector 7 (the shaded portions surrounded by dotted lines in FIG. 7, for example, N2(41b), N2(41c)) are emitted to the irradiation target S. In this state, as illustrated in FIG. 7, there is no overlapping of the second electron beams B2 emitted to the irradiation target S. However, when $5 \times 5 = 25$ second electron beams B2 at the third time deflected by the electron beam deflector 7 (the portions including symbol + in the area surrounded by dotted lines in FIG. 7, for example, N3(41a), N3(41b), N3(41c)) are emitted to the irradiation target S, for example, N3(41c) is emitted to the region that has already been irradiated at the first time with the second electron beam N1(41b) in a duplicated manner. Then, the second electron beams B2 at the n-th and subsequent times, such as N2(41b) at the fourth time, N3(41b) at the fifth time, or the like, will be emitted to any of regions in a duplicated manner.

In contrast, as illustrated in FIG. 8, when emitting $5 \times 5 = 25$ second electron beams B2 at the third time (the portion including symbol + in the area surrounded by dotted lines in FIG. 8, for example, N3(41a), N3(41b), N3(41c)), it may be possible to increase the deflection level of the electron beam deflector 7 so that, for example, N3(41c) does not overlap the irradiation region with the second electron beam N2(41b) provided at the second time. However, the increased deflection level of the electron beam deflector 7 causes a missing to occur in an irradiation region with the second electron beam B2 between N2(41a) and N3(41a).

In the third embodiment, as illustrated in FIG. 9, when the region irradiated with the second electron beam B2 formed on the image plane (the region where solid black circles are grouped in FIG. 9) is defined as a second electron beam irradiation region, the second electron beam irradiation region has a shape that can completely fill the irradiation target S without missing and overlapping. Note that, in the third embodiment, the second electron beam irradiation region is nonlinear. In other words, the second electron beams B2 are not aligned linearly. In the example illustrated in FIG. 9, divided regions created by dividing the irradiation target S into the same shapes (S1, S2, S3, ..., Sn) match the second electron beam irradiation regions. Therefore, in the example illustrated in FIG. 9, the irradiation target S can be scanned with formed $m \times n$ second electron beams B2 without occurrence of overlapping or missing.

To have such a shape of the second electron beam irradiation region that can completely fill the irradiation target S without missing and overlapping, the emission arrangement and the lens arrangement can be formed of, for example, three or more odd number of points aligned linearly at equal intervals, the four corners and the center of a square, or the six corners and the center of a regular hexagon. Note that the above examples are typical examples, and another arrangement may be employed as long as the third embodiment can be implemented. The emission arrangement and the lens arrangement have the same size or are geometrically similar arrangement to each other when viewed in the Z direction.

Next, a relationship for the second electron beam irradiation regions to be able to completely fill the irradiation target S without missing and overlapping will be described with reference to FIG. 3 and FIG. 10 to FIG. 16. First, a case where the emission arrangement and the lens arrangement are formed of the four corners and the center of a square or the six corners and the center of a regular hexagon will be described. As illustrated in FIG. 3 and FIG. 10, the first electron beams B1 emitted from the electron source 2 passes through lenses of the multi-lens array (MLA) 4, and the second electron beams B2 are formed on the image plane IS. In this state, the position vector P of the beam on the image plane IS can be expressed in the following Equation (1). Note that the symbol "C" in FIG. 10 represents a direction connecting the center emission position of the emission arrangement and a lens arranged at the center of the lens arrangement (hereafter, which may be referred to as "central axis"). More specifically, the direction is a direction connecting the centers to each other when the emission arrangement and the lens arrangement are formed of the four corners and the center of a square, and the direction is a direction connecting the centers to each other when the emission arrangement and the lens arrangement are formed of the six corners and the center of a regular hexagon. The meanings of symbols in Equation (1) are denoted after Equation (1). Note that the meanings of symbols in other Equations described later are also denoted together.

[Equation 1]

$$\vec{P} = \frac{u+v}{u}\vec{S} - \frac{v}{u}\vec{R} \qquad (1)$$

where

$P_s$: the distance from the center of the plurality of second electron beams formed when passing through a lens arranged at the center of the lens arrangement to the center of the plurality of second electron beams formed when passing through a lens arranged adjacent to the lens arranged at the center of the lens arrangement,

$\vec{P_s}$: a vector of the above $P_s$,

$P$: the distance from the center second electron beam of the plurality of second electron beams formed when passing through a lens arranged at the center of the lens arrangement to the second electron beam adjacent to the center second electron beam,

$\vec{P}$: a vector of the above $P$,

$P'$: the distance from the center second electron beam of the plurality of second electron beams formed when passing through a lens arranged at the center of the lens arrangement to the second electron beam adjacent to the center second electron beam,

$\vec{P'}$: vector of the above $P'$,

$h$: an integer,

$i$: an integer,

$\phi$: the angle formed between $\vec{P'}$ and $\vec{P}$,

$\theta$: the angle formed between $P$ and $\overline{P_s}$,

$u$: the distance from the electron source to the multi-lens array,

$v$: the distance from the multi-lens array to the image plane,

$\vec{R}$: a vector from the center emission position of the emission arrangement to an emission position adjacent to the center emission position, and

$\vec{S}$: a vector from the center lens of the lens arrangement to a lens adjacent to the center lens.

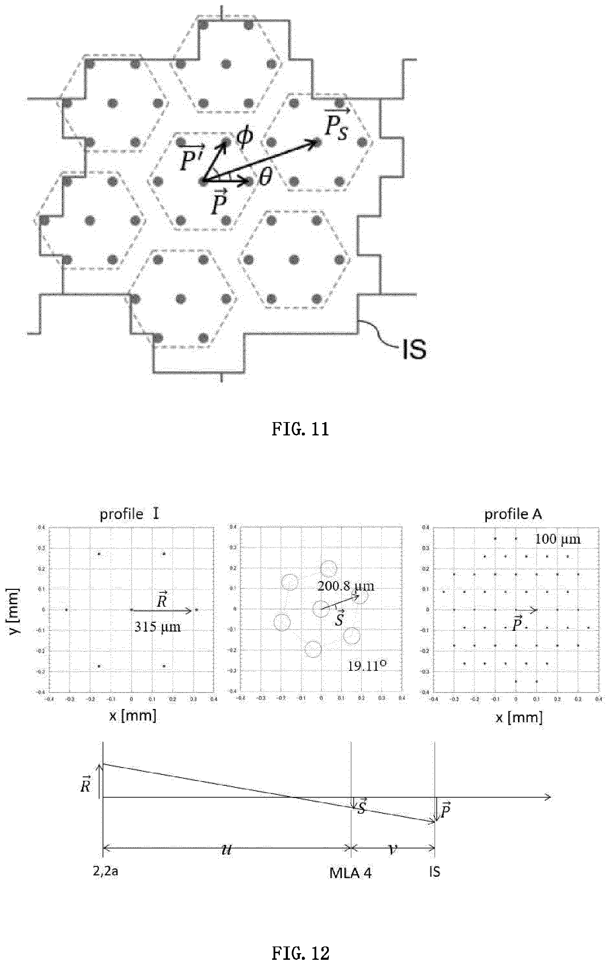

FIG. 11 is a diagram of the image plane IS viewed in the Z direction when the emission arrangement and the lens arrangement are formed of the six corners and the center of a regular hexagon. The meanings of the symbols in FIG. 11 are as denoted above. The second electron beam B2 formed on the image plane IS can be expressed by a basis vector represented by Equation (2) below. Further, Equation (3) is derived from Equation (2), and the angle $\theta$ formed between the vector P and the vector Ps can be expressed by Equation (5) with a relationship of Equation (4) being taken into consideration.

[Equation 2]

$$\vec{P_S} = h\vec{P} + i\vec{P'} \qquad (2)$$

$$P_s = \left|\vec{P_S}\right| = \sqrt{h^2P^2 + i^2P'^2 + 2hiPP'\cos\phi} \qquad (3)$$

$$\begin{aligned}\vec{P} \cdot \vec{P_S} &= PP_S\cos\theta \\ &= \vec{P} \cdot \left(h\vec{P} + i\vec{P'}\right) \\ &= hP^2 + iPP'\cos\phi\end{aligned} \qquad (4)$$

$$\cos\theta = \frac{hP + iP'\cos\phi}{\sqrt{h^2P^2 + i^2P'^2 + 2hiPP'\cos\phi}} \qquad (5)$$

In Equation (1) expressing the position vector P of a beam on the image plane IS described above, when the first electron beam B1 passes through the central axis C of the multi-lens array 4, the absolute value of the vector R can be expressed by Equation (6) below. Further, when the first electron beam B1 emitted from the central axis C passes through a lens of the multi-lens array 4 off from the central axis C, the absolute value of the vector S can be expressed by Equation (7) below.

[Equation 3]

$$\text{When } \vec{S} = (0,0), \quad \left|\vec{R}\right| = \frac{u}{v}\left|\vec{P}\right| \qquad (6)$$

$$\text{When } \vec{R} = (0,0), \quad \left|\vec{S}\right| = \frac{u}{u+v}\left|\vec{P_S}\right| \qquad (7)$$

By applying design information such as a distance u from the electron source 2 to the multi-lens array 4, a distance v from the multi-lens array 4 to the image plane IS, and the number of first electron beams B1 and the number of lenses to the above Equations (3), (5), (6), and (7), it is possible to calculate the angle $\theta$ at which, when the emission arrangement viewed in the Z direction is defined as a reference, the lens arrangement viewed in the Z direction is rotated about the center of the emission arrangement as the rotation axis C from arrangement that is the same as or geometrically similar arrangement to the emission arrangement.

In the example illustrated in FIG. 11 and FIG. 12, a case where the number of first electron beams B1 is seven (the six corners and the center of a regular hexagon), the number of lenses of the multi-lens array 4 is seven (the six corners and the center of a regular hexagon), u = 63 mm, v = 20 mm, and P = 100 um is assumed. In such a case, since P' = P, $\phi$ = 60°, h = 2, and i = 1, then $\theta$, R, and S can be calculated as follows.

[Equation 4]

$$P_s = \sqrt{7} \times 100 = 264.6 \; \mu m$$
$$\cos \theta = \frac{2.5}{\sqrt{7}}$$
$$\therefore \; \theta = 19.11°$$

$$R = \frac{63}{20} \times 100 = 315.0 \; \mu m$$
$$S = \frac{63}{63 + 20} \times 264.6 = 200.8 \; \mu m$$

FIG. 12 illustrates the arrangement based on numerical values obtained from the above calculation. The emission positions of the first electron beams B1 are set at the center of the electron source 2 and at a distance of 315 um (vector R) from the central axis (center-to-center distance), and the lenses are arranged at the center of the multi-lens array (MLA) 4 and at a distance of 200.8 um (vector S) from the central axis (center-to-center distance). Further, when viewed in the Z direction, the emission positions of the first electron beams B1 and the lenses are relatively rotated from their geometrically similar positions by $\theta$ = 19.11° in the counterclockwise direction, and thereby 49 second electron beams B2 at intervals of 100 um in the vector P direction can be formed on the image plane IS. The shape of the 49 formed second electron beams B2 is a shape that enables divided regions S1, S2, ..., Sn (respective divided regions have the same shape) to be irradiated that can completely fill the irradiation target S illustrated in FIG. 9 without missing or overlapping. Therefore, with the use of the electron gun 1 in which the electron source 2 and the multi-lens array 4 are designed as illustrated in FIG. 12, it is possible to scan the irradiation target S with the second electron beams B2 without missing or overlapping of irradiation.

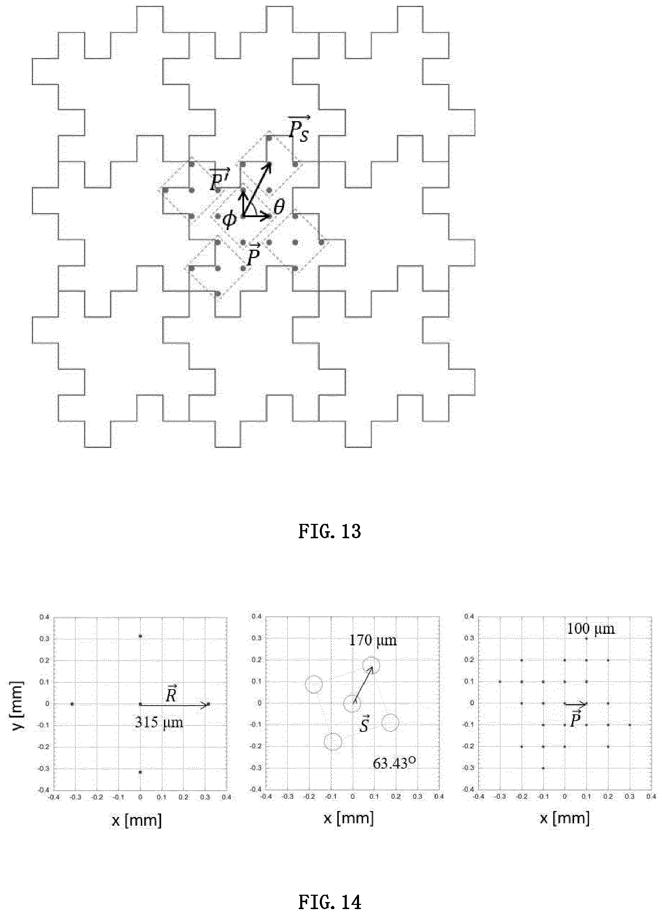

FIG. 13 and FIG. 14 illustrate an example of a case where the number of first electron beams B1 is five (the four corners and the center of a square) and the number of lenses of the multi-lens array 4 is five (the four corners and the center of a square). A case where u = 63 mm, v = 20 mm, and P = 100 um is assumed. In such a case, as illustrated in FIG. 13, since P' = P, $\phi$ = 90°, h = 2, and i = 1, then $\theta$, R, and S can be calculated as follows.

[Equation 5]

$$P_s = \sqrt{5} \times 100 = 223.6 \ \mu m$$

$$\cos \theta = \frac{1}{\sqrt{5}}$$

$$\therefore \ \theta = 63.43°$$

$$R = \frac{63}{20} \times 100 = 315.0 \ \mu m$$

$$S = \frac{63}{63 + 20} \times 223.6 = 169.7 \ \mu m$$

FIG. 14 illustrates the arrangement based on numerical values obtained from the above calculation. The emission positions of the first electron beams B1 are set at the center of the electron source 2 and at a distance of 315 um (vector R) from the central axis (center-to-center distance), and the lenses are arranged at the center of the multi-lens array (MLA) 4 and at a distance of 170 um (vector S) from the central axis (center-to-center distance). Further, when viewed in the Z direction, the emission positions of the first electron beams B1 and the lenses are relatively rotated from their geometrically similar positions by θ = 63.43° in the counterclockwise direction, and thereby 25 second electron beams B2 at intervals of 100 um in the vector P direction can be formed on the image plane IS. The shape of the 25 formed second electron beams B2 corresponds to a divided region having the same shape that can completely fill the irradiation target S illustrated in FIG. 13 without missing or overlapping.

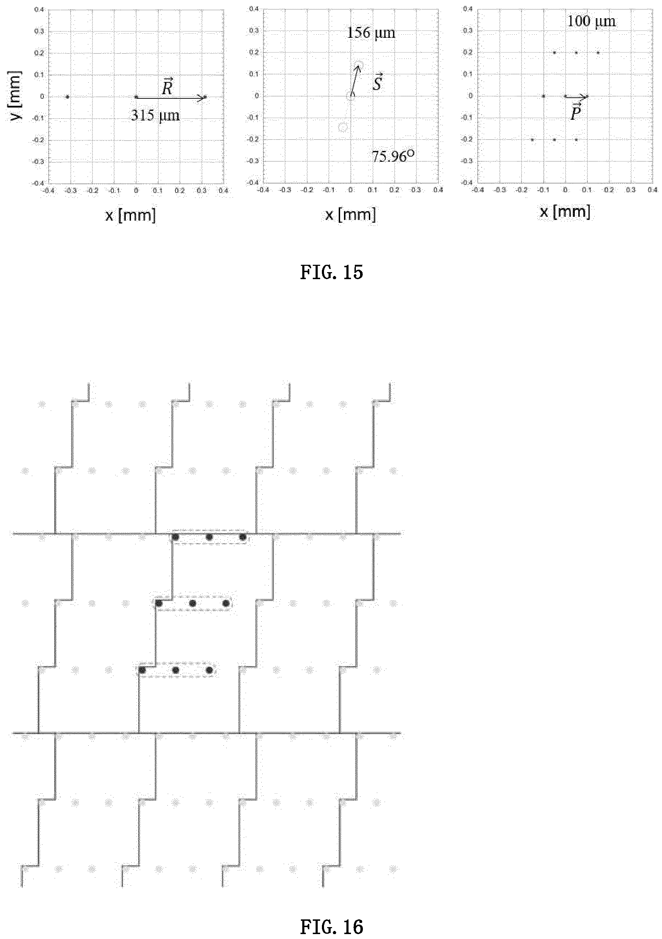

Next, a case where the emission arrangement and the lens arrangement are formed of three or more odd number of points aligned linearly at equal intervals will be described. As illustrated in FIG. 2, when the emission arrangement viewed in the Z direction is defined as a reference, when the lens arrangement viewed in the Z direction is the same as or geometrically similar arrangement to the emission arrangement (in other words, the rotation angle is 0 degree), the second electron beams B2 at equal intervals are formed linearly on the image plane IS. In contrast, as illustrated in FIG. 15, when the emission arrangement viewed in the Z direction is defined as a reference, when the lens arrangement viewed in the Z direction is arranged at a position rotated about the center of the emission arrangement as a rotation axis, a parallelogram second electron beam irradiation region is formed on the image plane IS, as illustrated in FIG. 16. While the size of the formed parallelogram is changed in accordance with the angle to rotate, the obtained shape is still a parallelogram. Further, the parallelogram is a shape that can completely fill an irradiation target without missing and overlapping. Therefore, when the emission arrangement and the lens arrangement are formed of three or more odd number of points aligned linearly at equal intervals, the rotation angle may be any angle, and the interval to scan the second electron beam irradiation region can be adjusted in accordance with the rotation angle. Further, the number of odd-number points is not particularly limited as long as it is greater than or equal to 3 and may be 5, 7, 9, 11, 13, 15, or the like. The upper limit of odd-number points is not particularly limited in principle. The upper limit is set as appropriate taking the size of the irradiation target S, the spot size of the second electron beam B2, or the like into consideration.

FIG. 15 illustrates an example of a case where the number of first electron beams B1 is three at equal intervals, the number of lenses of the multi-lens array 4 is three at equal intervals, the distance from the electron source to the multi-lens array is 63 mm, and the distance from the multi-lens array to the image plane is 20 mm. The emission positions of the first electron beams B1 are set at the center of the electron source 2 and at a distance of 315 um (vector R) from the central axis (center-to-center distance), and the lenses are arranged at the center of the multi-lens array (MLA) 4 and at a distance of 156 um (vector S) from the central axis (center-to-center distance). Further, when viewed in the Z direction, the emission positions of the first electron beams B1 and the lenses are relatively rotated from their geometrically similar positions by θ = 75.96° in the counterclockwise direction, and thereby nine second electron beams B2 at intervals of 100 um in the vector P direction can be formed on the image plane IS.

Note that the above description is description when the first electron beam emission positions are formed in the electron source 2. When the first electron beam emission positions are formed in the electron beam divider, it is only necessary to replace the term of the electron source 2 with the term of the electron beam divider in the above description. Further, the size (preferably, the diameter) of the first electron beam B1, the second electron beam B2, and the lens 41 illustrated in the drawings are mere approximation. The size of the first electron beam B1, the second electron beam B2, and the lens 41 can be adjusted as appropriate within the intended scope of the second and third embodiments.

As described above, in the third embodiment, it is possible to scan the irradiation target S with formed second electron beams B2 without occurrence of overlapping or missing. Therefore, the third embodiment is particularly useful for scanning type electron beam applicators 10. For example, the scanning type electron beam applicator 10 may be, but is not limited thereto, a scanning electron microscope, an electron beam inspection device, a scanning transmission electron microscope, or the like. Naturally, the third embodiment may be applied to a non-scanning type electron beam applicator 10.

The third embodiment achieves the following advantageous effects in addition to the advantageous effects described in the above second embodiment.

(1) In the third embodiment, compared with the second embodiment, the shapes of the emission arrangement and the lens arrangement are specified, and the rotation angle of the lens arrangement when the emission arrangement viewed in the Z direction is defined as a reference is further specified. Therefore, the spacing between the second electron beams B2 formed on the image plane IS can be smaller than that in the second embodiment.

(2) When applied to the scanning type electron beam applicator, it is possible to scan the irradiation target S with the formed second electron beams B2 without occurrence of overlapping or missing.

[Second Embodiment of Multi-Electron Beam Forming Method]

Next, the second embodiment of the multi-electron beam forming method will be described. The second embodiment of the multi-electron beam forming method differs from the above (the embodiment of the multi-electron beam forming method (hereafter, which may be referred to as "first embodiment of the method")) in that the positional relationship between the first electron beam emission positions and lenses of the multi-lens array when viewed in the Z direction is controlled to be a preset positional relationship when a direction from the electron source 2 to the multi-lens array 4 is defined as the Z direction and emission positions when the first electron beams B1 are emitted from the electron source 2 are defined as the first electron beam emission positions, and the second embodiment of the multi-electron beam forming method is the same as the first embodiment of the method in other features. Therefore, in the second embodiment of the multi-electron beam forming method, features different from the first embodiment of the method will be mainly described, and the duplicated description for the features that have already been described in the first embodiment of the method will be omitted. Accordingly, it is apparent that, even when not explicitly described in the second embodiment of the multi-electron beam forming method, any feature that has already been described in the first embodiment of the method can be employed in the second embodiment of the multi-electron beam forming method.

In the second embodiment of the multi-electron beam forming method, the feature "the positional relationship between the first electron beam emission positions and lenses of the multi-lens array when viewed in the Z direction is controlled to be a preset positional relationship when a direction from the electron source 2 to the multi-lens array 4 is defined as the Z direction and emission positions when the first electron beams B1 are emitted from the electron source 2 are defined as the first electron beam emission positions" is the same as described in the above second and third embodiments. Accordingly, the specific description of each step of the second embodiment of the multi-electron beam forming method has been substantially provided in the second and third embodiments and thus is omitted here.

Further, when a scanning step of scanning the irradiation target with multiple electron beams formed by the second embodiment of the multi-electron beam forming method is implemented (scanning method with multiple electron beams), the scan can be performed with the formed multiple electron beams after controlling the emission arrangement and the lens arrangement to be arranged as illustrated in the above third embodiment.

The second embodiment of the multi-electron beam forming method achieves the same advantageous effects as those described in the second and third embodiments.

[Industrial Applicability]

The electron gun, the electron beam applicator, and the multi-electron beam forming method disclosed in the present application can improve the yield of manufacturing of multi-lens arrays and reduce the running cost of the electron gun or the electron beam applicator. Therefore, the electron gun, the electron beam applicator, and the multi-electron beam forming method disclosed in the present application are useful for business entities that handle multiple electron beams.

[List of References]

| 1 | electron gun |
| 2 | electron source |
| 2a | photocathode |
| 2a1 | first face |
| 2a2 | second face |
| 2b | light source |
| 2c | optical splitter |
| 3 | anode |
| 4 | multi-lens array |
| 41, 41a to 41e | lens |
| 42 | rotation mechanism |
| 43 | motion mechanism |
| 5 | power supply |
| 6 | control unit |
| 7 | electron beam deflector |
| 10 | electron beam applicator |
| B | electron beam |
| B1, B1a to B1c | first electron beam |
| B2, B2a to B2c | second electron beam |
| CB | vacuum chamber |
| E | counterpart device |
| IS | image plane |
| L, La to Lc | excitation light beam |
| S | irradiation target |

**Claims**

1. An electron gun comprising:

   an electron source configured to generate releasable electrons;
   an anode configured to form an electric field between the electron source and the anode, extract the releasable electrons by the formed electric field, and form electron beams; and
   a multi-lens array,
   wherein when electron beams with which the multi-lens array is irradiated are defined as first electron beams, m first electron beams (m is any integer of two or greater) are formed,
   wherein the multi-lens array comprises n lenses (n is any integer of two or greater), and
   wherein the electron gun is configured to, when electron beams emitted from the multi-lens array are defined as second electron beams, form a maximum of m x n second electron beams when individual lenses of the multi-lens array are irradiated with the first electron beams from different positions.

2. The electron gun according to claim 1, wherein the electron source is a photocathode.

3. The electron gun according to claim 1, wherein the electron source comprises at least one field emitter or Schottky-type.

4. The electron gun according to claim 1, wherein the electron source comprises at least one thermionic cathode.

5. The electron gun according to any one of claims 1 to 4 further comprising a control unit,
   wherein the control unit is configured to, when a direction from the electron source to the multi-lens array is defined as a Z direction and emission positions from which the m first electron beams are emitted are defined as first electron beam emission positions, control a positional relationship between the first electron beam emission positions and the lenses of the multi-lens array when viewed in the Z direction to be a preset positional relationship.

6. The electron gun according to claim 5 further comprising a rotation mechanism that rotates the multi-lens array about the Z direction as a rotation axis,
   wherein the control unit controls the rotation mechanism.

7. The electron gun according to claim 5 further comprising a motion mechanism that moves the multi-lens array in the Z direction as a motion direction,
wherein the control unit controls the motion mechanism.

8. The electron gun according to claim 5, wherein when arrangement of the first electron beam emission positions is defined as emission arrangement, and arrangement of lenses of the multi-lens array is defined as lens arrangement,

the emission arrangement and the lens arrangement are the same or geometrically similar arrangement, and when the emission arrangement viewed in the Z direction is defined as a reference, the lens arrangement viewed in the Z direction is arranged at a position rotated about the center of the emission arrangement as a rotation axis so as not to be the same as or geometrically similar arrangement to the emission arrangement.

9. The electron gun according to claim 8, wherein the emission arrangement and the lens arrangement are any one selected from a group consisting of

three or more odd number of points aligned linearly at equal intervals,
the four corners and the center of a square, and the six corners and the center of a regular hexagon.

10. An electron beam applicator including the electron gun according to any one of claims 1 to 4, wherein the electron beam applicator is:

a free electron laser accelerator,
an electron microscope,
an electron holography device,
an electron beam drawing device,
an electron diffractometer,
an electron beam inspection device,
an electron beam metal additive manufacturing device,
an electron beam lithography device,
an electron beam processing device,
an electron beam curing device,
an electron beam sterilization device,
an electron beam disinfection device,
a plasma generation device,
an atomic element generation device,
a spin-polarized electron beam generation device,
a cathodoluminescence device, or
an inverse photoemission spectroscopy device.

11. A multi-electron beam forming method comprising:

a first electron beam forming step; and
a second electron beam forming step,
wherein the first electron beam forming step includes
emitting m first electron beams (m is any integer of two or greater) from an electron source by forming an electric field between the electron source configured to generate releasable electrons and an anode, or
forming m first electron beams (m is any integer of two or greater) by forming an electric field between the electron source configured to generate releasable electrons and an anode to extract an electron beam and dividing the extracted electron beam, and
wherein the second electron beam forming step includes
forming a maximum of m x n second electron beams by irradiating a multi-lens array having n lenses (n is any integer of two or greater) with the m first electron beams and causing the first electron beams to enter individual lenses of the multi-lens array, the individual lenses being irradiated with the first electron beams from different positions.

12. The multi-electron beam forming method according to claim 11, wherein the electron source is any one selected from a group consisting of a photocathode, a field emitter, and a Schottky-type.

**13.** The multi-electron beam forming method according to claim 11,

wherein the electron source is a thermionic cathode, and
wherein the first electron beam forming step includes
forming m first electron beams (m is any integer of two or greater) by forming an electric field between the electron source configured to generate releasable electrons and an anode to extract an electron beam and dividing the extracted electron beam.

**14.** The multi-electron beam forming method according to any one of claims 11 to 13, wherein when a direction from the electron source to the multi-lens array is defined as a Z direction and emission positions at which the first electron beams are emitted when emitted from the electron source are defined as first electron beam emission positions, a positional relationship between the first electron beam emission positions and the lenses of the multi-lens array when viewed in the Z direction is controlled to be a preset positional relationship.

**15.** The multi-electron beam forming method according to claim 14,

wherein when arrangement of the first electron beam emission positions is defined as emission arrangement, and arrangement of lenses of the multi-lens array is defined as lens arrangement,
the emission arrangement and the lens arrangement are the same or geometrically similar arrangement, and
when the emission arrangement viewed in the Z direction is defined as a reference, the lens arrangement viewed in the Z direction is arranged at a position rotated about the center of the emission arrangement as a rotation axis so as not to be the same as or geometrically similar arrangement to the emission arrangement.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

## INTERNATIONAL SEARCH REPORT

| International application No. |
|---|
| **PCT/JP2022/040542** |

### A.　CLASSIFICATION OF SUBJECT MATTER

*H01J 37/06*(2006.01)i; *H01J 37/073*(2006.01)i; *H01J 37/28*(2006.01)i; *H01J 1/34*(2006.01)i
FI:　H01J37/06; H01J1/34; H01J37/28 B; H01J37/28 C; H01J37/073

According to International Patent Classification (IPC) or to both national classification and IPC

### B.　FIELDS SEARCHED

Minimum documentation searched (classification system followed by classification symbols)

H01J37/06; H01J37/073; H01J37/28; H01J1/34

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C.　DOCUMENTS CONSIDERED TO BE RELEVANT

| Category* | Citation of document, with indication, where appropriate, of the relevant passages | Relevant to claim No. |
|---|---|---|
| A | JP 2017-108146 A (MAPPER LITHOGRAPHY IP B.V.) 15 June 2017 (2017-06-15)<br>entire text, all drawings | 1-15 |
| A | JP 2016-522572 A (MAPPER LITHOGRAPHY IP B.V.) 28 July 2016 (2016-07-28)<br>entire text, all drawings | 1-15 |
| A | JP 2013-544031 A (MAPPER LITHOGRAPHY IP B.V.) 09 December 2013 (2013-12-09)<br>entire text, all drawings | 1-15 |
| A | US 2020/0126751 A1 (ICT INTEGRATED CIRCUIT TESTING GESELLSCHAFT FUR HALBLEITERPRUFTECHNIK MBH) 23 April 2020 (2020-04-23)<br>entire text, all drawings | 1-15 |

☐ Further documents are listed in the continuation of Box C.　　☑ See patent family annex.

| | | |
|---|---|---|
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **08 December 2022** | **20 December 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2022/040542**

| Patent document cited in search report | | | Publication date (day/month/year) | Patent family member(s) | | | Publication date (day/month/year) |
|---|---|---|---|---|---|---|---|
| JP | 2017-108146 | A | 15 June 2017 | US | 2012/0273690 | A1 | |
| | | | | entire text, all drawings | | | |
| | | | | WO | 2012/148267 | A1 | |
| | | | | EP | 2702595 | A1 | |
| | | | | EP | 3648114 | A1 | |
| | | | | NL | 2007604 | A | |
| | | | | TW | 201301330 | A | |
| | | | | CN | 103620693 | A | |
| | | | | KR | 10-2014-0043355 | A | |
| | | | | RU | 2013152639 | A | |
| | | | | NL | 2010615 | A | |
| JP | 2016-522572 | A | 28 July 2016 | US | 2016/0071696 | A1 | |
| | | | | entire text, all drawings | | | |
| | | | | WO | 2014/177718 | A1 | |
| | | | | EP | 3020062 | A1 | |
| | | | | EP | 3651183 | A1 | |
| | | | | NL | 2010760 | C | |
| | | | | NL | 2010760 | C2 | |
| JP | 2013-544031 | A | 09 December 2013 | US | 2012/0293780 | A1 | |
| | | | | entire text, all drawings | | | |
| | | | | US | 8916837 | B2 | |
| | | | | US | 2012/0292524 | A1 | |
| | | | | US | 2012/0145915 | A1 | |
| | | | | US | 2012/0286168 | A1 | |
| | | | | US | 2012/0287410 | A1 | |
| | | | | US | 2012/0292491 | A1 | |
| | | | | US | 2012/0293810 | A1 | |
| | | | | WO | 2012/062932 | A1 | |
| | | | | WO | 2012/065941 | A1 | |
| | | | | WO | 2012/062726 | A1 | |
| | | | | WO | 2012/062727 | A1 | |
| | | | | WO | 2012/062854 | A1 | |
| | | | | WO | 2012/062931 | A1 | |
| | | | | WO | 2012/062934 | A1 | |
| | | | | EP | 2638560 | A1 | |
| | | | | EP | 2638559 | A1 | |
| | | | | EP | 2638561 | A1 | |
| | | | | EP | 2638562 | A1 | |
| | | | | EP | 3640968 | A1 | |
| | | | | TW | 201239940 | A | |
| | | | | TW | 201236045 | A | |
| | | | | KR | 10-2013-0126936 | A | |
| | | | | TW | 201230132 | A | |
| | | | | TW | 201232192 | A | |
| | | | | TW | 201234401 | A | |
| | | | | TW | 201234405 | A | |
| | | | | TW | 201239941 | A | |
| | | | | KR | 10-2013-0139308 | A | |
| | | | | RU | 2013126794 | A | |
| US | 2020/0126751 | A1 | 23 April 2020 | WO | 2020/078610 | A1 | |
| | | | | entire text, all drawings | | | |

Form PCT/ISA/210 (patent family annex) (January 2015)

**INTERNATIONAL SEARCH REPORT**
Information on patent family members

International application No.

**PCT/JP2022/040542**

| Patent document cited in search report | Publication date (day/month/year) | Patent family member(s) | | Publication date (day/month/year) |
|---|---|---|---|---|
| | | EP 3867941 A1 | | |
| | | TW 202018751 A | | |
| | | CN 112840431 A | | |
| | | KR 10-2021-0076117 A | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9245708 A
- JP 5808021 B
- JP 3537779 B
- JP 2013030567 A
- JP 2014053408 A